# EUROPEAN PATENT APPLICATION

(11) **EP 3 618 574 A1**
(43) Date of publication of application: **04.03.2020**
(21) Application number: 18790113.7
(22) Date of filing: 05.04.2018
(51) Int. Cl.: H05B 33/10, B26D 7/08, B26F 1/44, H01L 51/50, H05B 33/04

(54) **METHOD FOR MANUFACTURING ORGANIC DEVICE**

(30) Priority: 25.04.2017 JP 2017086103
(71) Applicant: Sumitomo Chemical Company, Limited, Tokyo 104-8260 (JP)
(72) Inventor: FUJII Takashi, Niihama-shi Ehime 792-0015 (JP); MATSUMOTO Yasuo, Niihama-shi Ehime 792-0015 (JP); MORISHIMA Shinichi, Tsukuba-shi Ibaraki 300-3294 (JP)
(74) Representative: J A Kemp LLP
(86) International application number: PCT/JP2018/014548
(87) International publication number: WO 2018/198705

(57) **Abstract**

A method for manufacturing an organic device (1) includes a forming step of forming a plurality of organic device parts (10) in which at least a first electrode layer (5), an organic functional layer (7) and a second electrode layer (9) are laminated in this order in one direction at predetermined intervals on one main surface (3a) of a support substrate (3) which extends in the one direction; a bonding step of bonding a sealing member (11) which extends in the one direction in the one direction so that respective parts of the first electrode layer (5) and the second electrode layer (9) in the organic device parts (10) are exposed and straddle the plurality of organic device parts (10); and a cutting step of separating the plurality of organic device parts (10) to which the sealing member (11) is bonded into pieces, and in the bonding step, the sealing member (11) is bonded to the organic EL part (10) using a pressure sensitive adhesive, and in the cutting step, a cutting blade B is made to enter from the side of the sealing member (11).

## Description

### Technical Field

The present invention relates to a method for manufacturing an organic device.

### Background Art

Regarding a conventional method for manufacturing an organic device, for example, the method described in Patent Literature 1 is known. The method for manufacturing an organic device described in Patent Literature 1 includes a sealing step of adhering a sealant to a base material using a thermosetting adhesive so that an organic functional element is covered after a step of forming the organic functional element on the base material, and a cutting step of performing heat melt cutting before the thermosetting adhesive is cured after the sealant is adhered, and separating individual organic devices into pieces.

### Citation List

### Patent Literature

[Patent Literature 1] Japanese Unexamined Patent Application Publication No. 2010-103040

### Summary of Invention

### Technical Problem

In the conventional method for manufacturing an organic device, when heat melt cutting is performed before the thermosetting adhesive used for adhering a sealing member is cured, this is intended to prevent peeling off of the sealing member from the organic functional element during cutting. In the conventional method, a cutting blade that is heated by a heating unit is used for heat melt cutting. However, in heat melt cutting, heat may be transmitted to the device, and there is a risk of the device being thermally deteriorated. In addition, in heat melt cutting, since a molten thermosetting adhesive and the like may be attached to the cutting blade, and an operation of attachment with respect to the cutting blade may occur, the maintainability is poor. In addition, in heat melt cutting, as described above, the configuration is complicated because the cutting blade is heated by the heating unit in the configuration. Therefore, the reliability of the organic device tends to decrease and it is difficult to efficiently separate individual organic devices into pieces.

According to one aspect of the present invention, there is provided a method for manufacturing organic devices that can be efficiently separated into pieces while minimizing reduction in reliability of the organic device.

### Solution to Problem

A method for manufacturing an organic device according to one aspect of the present invention includes a forming step of forming a plurality of organic device parts in which at least a first electrode layer, an organic functional layer and a second electrode layer are laminated in this order in one direction at predetermined intervals on one main surface of a support substrate which extends in the one direction; a bonding step of bonding a sealing member which extends in the one direction in the one direction so that respective parts of the first electrode layer and the second electrode layer in the organic device parts are exposed and straddle the plurality of organic device parts; and a cutting step of separating the plurality of organic device parts to which the sealing member is bonded into pieces, wherein, in the bonding step, the sealing member including a sealing substrate and a pressure sensitive adhesive is bonded to the organic device part, and wherein, in the cutting step, a cutting blade is made to enter from the side of the sealing member.

In the method for manufacturing an organic device according to one aspect of the present invention, the sealing member including a sealing substrate and a pressure sensitive adhesive is bonded to the organic device part. Then, the cutting blade is made to enter from the side of the sealing member and the organic devices are separated into pieces. The pressure sensitive adhesive is used for adhesion when a pressure is applied and has flexibility without being cured after adhesion. Therefore, the pressure sensitive adhesive adheres the sealing member and the organic device part due to a pressure generated when the cutting blade enters, and also can prevent the sealing substrate and the pressure sensitive adhesive from peeling off when the cutting blade is retracted. Therefore, in the method for manufacturing an organic device, since it is possible to prevent the occurrence of defects due to delamination, it is possible to minimize reduction in reliability. In the method for manufacturing an organic device, since no thermosetting adhesive is used, no heat melt cutting is required. Therefore, in the method for manufacturing an organic device, since thermal deterioration does not occur in the device and a thermosetting adhesive and the like are not attached to the cutting blade, the maintainability is favorable, and since the heating unit is not necessary, the configuration can be simplified. Therefore, in the method for manufacturing an organic device, it is possible to efficiently separate the organic device into pieces while minimizing reduction in reliability of the organic device.

In one embodiment, in the forming step, the plurality of organic device parts may be formed at predetermined intervals in another direction orthogonal to the one direction, and in the bonding step, the sealing member may be bonded in the one direction to each of rows of the plurality of organic device parts arranged parallel to the other direction. Thus, it is possible to efficiently produce the organic device by bonding the sealing member in multiple rows.

In one embodiment, in the cutting step, the plurality of organic device parts may be separated into pieces at the same time using a plurality of cutting blades having a frame shape. Thereby, it is possible to efficiently separate the organic device into pieces. In a conventional heat melt cutting method, a cutting blade having a heating unit is used. In the conventional method, when a plurality of cutting blades are used, since it is necessary to provide a heating unit for each of the cutting blades, the configuration is complicated. In the method for manufacturing an organic device according to this embodiment, since no heating unit is required, even though a plurality of cutting blades are used, it is possible to efficiently separate the organic device into pieces with a simple configuration.

In one embodiment, in the cutting step, a cutting unit including a cutting blade provided in a base and a pair of elastic members which are disposed at positions on both sides of the cutting blade in the base and of which the tips protrude more than the tip of the cutting blade and which have elasticity may be used. When the cutting blade is made to enter from the side of the sealing member, the elastic members may contract, and when the cutting blade is retracted, the elastic members may extend. In this method, when the elastic members of which the tips protrude more than the tip of the cutting blade are used, the sealing member is pressed by the elastic members when the cutting blade enters or is retracted. Thereby, a pressure can be applied to the pressure sensitive adhesive when the cutting blade is made to enter, and it is possible to prevent the sealing substrate and the pressure sensitive adhesive from peeling off due to the sealing substrate pulled by the cutting blade when the cutting blade is retracted. Therefore, it is possible to prevent the occurrence of defects such as the occurrence of dark spots due to delamination. As a result, it is possible to minimize reduction in reliability of the organic device.

### Advantageous Effects of Invention

According to one aspect of the present invention, it is possible to efficiently separate an organic device into pieces while minimizing reduction in reliability of the organic device.

### Brief Description of Drawings

FIG. 1 is a cross-sectional view of an organic EL element produced by a method for manufacturing an organic device according to an embodiment.
FIG. 2 is a flowchart showing a method for manufacturing an organic EL element.
FIG. 3 is a perspective view showing a state in which a sealing member is bonded to an organic device part.
FIG. 4 is a diagram for explaining a cutting step.
FIG. 5 is a diagram for explaining the cutting step.
FIG. 6 is a diagram showing a cutting unit.
FIG. 7(a), FIG. 7(b), and FIG. 7(c) are diagrams for explaining details of the cutting step.
FIG. 8 is a diagram showing a cutting unit according to a modified example.

### Description of Embodiments

Exemplary embodiments of the present invention will be described below in detail with reference to the appended drawings. Here, the same or corresponding components are denoted with the same reference numerals in the following description of drawings, and redundant descriptions thereof will be omitted.

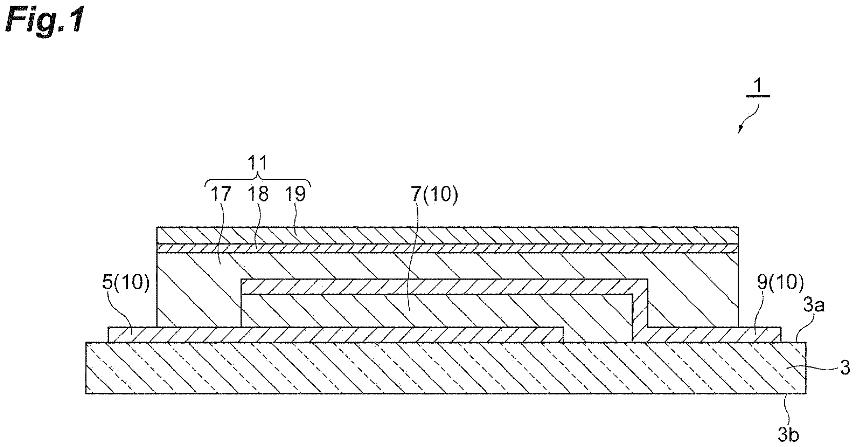

As shown in FIG. 1, an organic EL element (organic device) 1 produced by a method for manufacturing an organic device of the present embodiment includes a support substrate 3, an anode layer (first electrode layer) 5, an organic functional layer 7, a cathode layer (second electrode layer) 9, and a sealing member 11. The anode layer 5, the organic functional layer 7 and the cathode layer 9 constitute an organic EL part (organic device part) 10.

[Support substrate] The support substrate 3 is made of a resin having transparency with respect to visible light (light with a wavelength of 400 nm to 800 nm). The support substrate 3 is a film-like substrate (a flexible substrate and a substrate having flexibility). The thickness of the support substrate 3 is, for example, 30 µm or more and 500 µm or less. When the support substrate 3 is made of a resin, preferably, the thickness is 45 µm or more in consideration of substrate deflection, wrinkles, and elongation during a continuous roll-to-roll method, and is 125 µm or less in consideration of flexibility.

The support substrate 3 is, for example, a plastic film. Examples of materials of the support substrate 3 include polyether sulfone (PES); polyester resins such as polyethylene terephthalate (PET) and polyethylene naphthalate (PEN); polyolefin resins such as polyethylene (PE), polypropylene (PP), and cyclic polyolefins; polyamide resins; polycarbonate resins; polystyrene resins; polyvinyl alcohol resins; saponified products of ethylene-vinyl acetate copolymers; polyacrylonitrile resins; acetal resins; polyimide resins; and epoxy resins.

Regarding the material of the support substrate 3, among the above resins, a polyester resin or a polyolefin resin is preferable and polyethylene terephthalate or polyethylene naphthalate is more preferable because then the heat resistance is high, the coefficient of linear expansion is low, and the production costs are low. These resins may be used alone and two or more thereof may be used in combination.

A gas barrier layer or a water barrier layer may be disposed on one main surface 3a of the support substrate 3. The other main surface 3b of the support substrate 3 is a light emitting surface. A light extraction film may be provided on the other main surface 3b of the support substrate 3. The light extraction film may be bonded to the other main surface 3b of the support substrate 3 via an adhesive layer. The support substrate 3 may be a thin film glass. When the support substrate 3 is a thin film glass, preferably, the thickness is 30 µm or more in consideration of the strength and 100 µm or less in consideration of flexibility.

[Anode layer] The anode layer 5 is disposed on the one main surface 3a of the support substrate 3. An electrode layer exhibiting light transmission is used for the anode layer 5. Regarding an electrode exhibiting light transmission, a thin film made of a metal oxide, a metal sulfide or a metal having high electrical conductivity can be used, and a thin film having high light transmittance is suitably used. For example, thin films made of indium oxide, zinc oxide, tin oxide, indium tin oxide (abbreviation ITO), indium zinc oxide (abbreviation IZO), gold, platinum, silver, copper, or the like are used. Among these, a thin film made of ITO, IZO, or tin oxide is suitably used.

Regarding the anode layer 5, a transparent conductive film made of an organic material such as polyaniline and derivatives thereof, polythiophene and derivatives thereof may be used. Regarding the anode layer 5, an electrode obtained by patterning the above exemplified metals or metal alloys in a mesh shape or an electrode in which nanowires containing silver are formed into a network shape may be used.

The thickness of the anode layer 5 can be determined in consideration of light transmission, electrical conductivity, and the like. The thickness of the anode layer 5 is generally 10 nm to 10 µm, preferably 20 nm to 1 µm, and more preferably 50 nm to 200 nm.

Examples of a method for forming the anode layer 5 include a dry film forming method such as a vacuum deposition method, a sputtering method, and an ion plating method, and a coating method such as an inkjet method, a slit coating method, a gravure printing method, a screen printing method, and a spray coating method. In the anode layer 5, additionally, a pattern can be formed using a photolithographic method, a dry etching method, a laser trimming method, or the like. Direct coating is performed on the support substrate 3 using a coating method, and thus a pattern can be formed without using a photolithographic method, a dry etching method, a laser trimming method, or the like.

[Organic functional layer] The organic functional layer 7 is disposed on the main surface (the side opposite to the surface in contact with the support substrate 3) of the anode layer 5 and the one main surface 3a of the support substrate 3. The organic functional layer 7 includes a light emitting layer. The organic functional layer 7 generally contains a light emitting material that mainly emits fluorescence and/or phosphorescence or a light emitting material and a dopant material for a light emitting layer that assists the light emitting material. For example, the dopant material for a light emitting layer is added to improve luminous efficiency or change a light emission wavelength. The light emitting material that emits fluorescence and/or phosphorescence may be a low-molecular-weight compound or a high-molecular-weight compound. Examples of organic materials constituting the organic functional layer 7 include a light emitting material that emits fluorescence and/or phosphorescence such as the following dye materials, metal complex materials, and polymeric materials and the following dopant materials for a light emitting layer.

### (Dye materials)

Examples of dye materials include cyclopentamine and derivatives thereof, tetraphenylbutadiene and derivatives thereof, triphenylamine and derivatives thereof, oxadiazole and derivatives thereof, pyrazoloquinoline and derivatives thereof, distyrylbenzene and derivatives thereof, distyrylarylene and derivatives thereof, pyrrole and derivatives thereof, thiophene compounds, pyridine compounds, perinone and derivatives thereof, perylene and derivatives thereof, oligothiophene and derivatives thereof, oxadiazole dimers, pyrazoline dimers, quinacridone and derivatives thereof, and coumarin and derivatives thereof.

### (Metal complex materials)

Examples of metal complex materials include metal complexes which contains a rare earth metal such as Tb, Eu, and Dy, or Al, Zn, Be, Pt, or Ir as a central metal, and have a oxadiazole, thiadiazole, phenylpyridine, phenylbenzimidazole, or quinoline structure or the like in a ligand. Examples of metal complexes include metal complexes emitting light in a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Polymeric materials)

Examples of polymeric materials include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinylcarbazole and derivatives thereof, and materials obtained by polymerizing the above dye materials or metal complex materials.

### (Dopant materials for a light emitting layer)

Examples of dopant materials for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl dyes, tetracene and derivatives thereof, pyrazolone and derivatives thereof, decacyclene and derivatives thereof, and phenoxazone and derivatives thereof.

The thickness of the organic functional layer 7 is generally about 2 nm to 200 nm. For example, the organic functional layer 7 is formed by a coating method using a coating solution (for example, an ink) containing the above light emitting material. A solvent for a coating solution containing a light emitting material is not limited as long as it dissolves the light emitting material. The above light emitting material may be formed by vacuum deposition.

### [Cathode layer]

The cathode layer 9 is disposed on the main surface (the side opposite to the surface in contact with the anode layer 5) of the organic functional layer 7 and the one main surface 3a of the support substrate 3. Regarding the material of the cathode layer 9, for example, alkali metals, alkaline earth metals, transition metals, and metals in Group 13 in the periodic table can be used. Regarding the material of the cathode layer 9, specifically, for example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the above metals, an alloy of one or more of the above metals and one or more of gold, silver, platinum, copper, manganese, titanium, cobalt, nickel, tungsten, and tin, or graphite or a graphite intercalation compound is used. Examples of alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

For the cathode layer 9, for example, a transparent conductive electrode made of a conductive metal oxide, a conductive organic material, or the like can be used. Specific examples of conductive metal oxides include indium oxide, zinc oxide, tin oxide, ITO, and IZO, and examples of conductive organic materials include polyaniline and derivatives thereof, polythiophene and derivatives thereof. The cathode layer 9 may have a laminate configuration in which two or more layers are laminated. An electron injection layer to be described below may be used as the cathode layer 9.

The thickness of the cathode layer 9 is set in consideration of the electrical conductivity and durability. The thickness of the cathode layer 9 is generally 10 nm to 10 µm, preferably 20 nm to 1 µm, and more preferably 50 nm to 500 nm.

Examples of a method for forming the cathode layer 9 include coating methods such as an inkjet method, a slit coating method, a gravure printing method, a screen printing method, and a spray coating method, a vacuum deposition method, a sputtering method, and a lamination method for thermocompression bonding a metal thin film, and a vacuum deposition method or a sputtering method is preferable.

### [Sealing member]

The sealing member 11 is disposed on the top part in the organic EL element 1 so that it covers at least the organic functional layer 7. The sealing member 11 includes an adhesive part 17, a barrier layer 18, and a sealing substrate 19. In the sealing member 11, the adhesive part 17, the barrier layer 18 and the sealing substrate 19 are laminated in this order. The adhesive part 17 is used to adhere the barrier layer 18 and the sealing substrate 19 to the anode layer 5, the organic functional layer 7, and the cathode layer 9. Specifically, the adhesive part 17 is a pressure sensitive adhesive. The pressure sensitive adhesive preferably contains an α-olefin resin and a tackifier. The α-olefin resin and the tackifier are not particularly limited and those conventionally known can be used. Examples of α-olefin resins include homopolymers or copolymers of polyethylene, polyisobutylene, and the like. Examples of copolymers include copolymers obtained by polymerizing two or more α-olefins and copolymers obtained by polymerizing an α-olefin and monomers (for example, styrene, a non-conjugated diene and the like) other than an α-olefin. The pressure sensitive adhesive may contain an additive. Examples of additives include a hygroscopic metal oxide (for example, calcium oxide, calcined hydrotalcite, and the like), and an inorganic filler (for example, silica, mica, talc, and the like) other than a hygroscopic metal oxide.

The barrier layer 18 has a gas barrier function, particularly, a water barrier function. The sealing substrate 19 is made of a metal foil, a transparent plastic film, a thin film glass having flexibility, or the like. The metal foil is preferably made of copper, aluminum, or stainless steel in consideration of barrier properties. The thickness of the metal foil is preferably thicker in consideration of prevention of pinholes, but it is preferably 10 µm to 50 µm in consideration of flexibility.

### [Method for manufacturing an organic EL element]

Subsequently, a method for manufacturing an organic EL element 1 having the above configuration will be described.

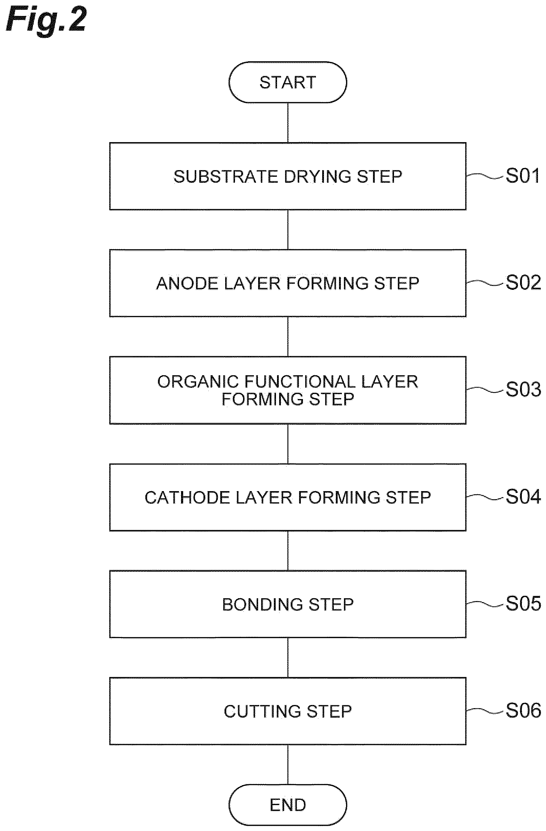

In a form in which the support substrate 3 is a substrate which has flexibility and extends in the longitudinal direction, a roll-to-roll method can be adopted from the substrate drying step S01 to the bonding step S05 shown in FIG. 2.

When the organic EL element 1 is produced, first, the support substrate 3 is heated and dried (substrate drying step S01). Next, the anode layer 5 is formed on the one main surface 3a of the dried support substrate 3 (anode layer forming step (forming step) S02). The anode layer 5 can be formed by a formation method exemplified in the description of the anode layer 5. On the support substrate 3, a plurality of anode layers 5 are formed in the longitudinal direction of the support substrate 3 at predetermined intervals, and a plurality of (two in the present embodiment) anode layers 5 are formed in the width direction (other direction orthogonal to one direction) of the support substrate 3 at predetermined intervals.

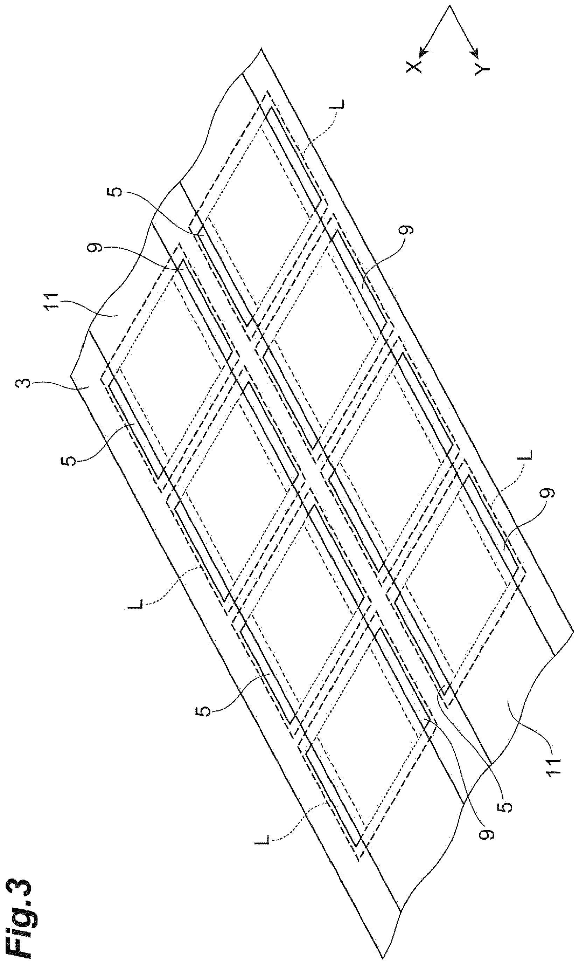

Subsequently, the organic functional layer 7 is formed on the anode layer 5 (organic functional layer forming step (forming step) S03). The organic functional layer 7 can be formed by a formation method exemplified in the description of the organic functional layer 7. Next, the cathode layer 9 is formed on the organic functional layer 7 (cathode layer forming step (forming step) S04). The cathode layer 9 can be formed by a formation method exemplified in the description of the cathode layer 9. Thereby, as shown in FIG. 3, on the support substrate 3, a plurality of organic EL parts 10 are formed in the longitudinal direction (Y direction in FIG. 3) of the support substrate 3 at predetermined intervals, and a plurality of (two in the present embodiment) organic EL parts 10 are formed in the width direction (X direction in FIG. 3) of the support substrate 3 at predetermined intervals. That is, two rows of the organic EL parts 10 are formed in the longitudinal direction of the support substrate 3.

Subsequently, the sealing member 11 is bonded (bonding step S05). The sealing member 11 has a predetermined width and extends in the longitudinal direction of the support substrate 3. Specifically, as shown in FIG. 3, the sealing member 11 has a width that is set so that respective parts of the anode layer 5 and the cathode layer 9 are exposed and has a strip shape. The sealing member 11 has flexibility. In the sealing member 11, the adhesive part 17 is provided on one surface of the sealing substrate 19. The sealing member 11 may be cut into a strip shape after the adhesive part 17 is formed on one surface of the sealing substrate 19 with the barrier layer 18 therebetween or the adhesive part 17 may be formed on one surface of the sealing substrate 19 with the barrier layer 18 therebetween after the sealing substrate 19 is cut into a strip shape.

The sealing member 11 is affixed to the organic EL part 10 so that a part of the anode layer 5 and a part of the cathode layer 9 are exposed. Specifically, the sealing member 11 is affixed in one direction to straddle the plurality of organic EL parts 10. In the roll-to-roll method, the organic EL part 10 and the sealing member 11 formed on the support substrate 3 are bonded while transporting the support substrate 3. The support substrate 3 and the sealing member 11 pass between rollers (not shown). Thereby, the support substrate 3 and the sealing member 11 are pressed by the rollers. Thereby, the adhesive part 17 is brought into close contact with the organic EL part 10. Bonding of the organic EL part 10 and the sealing member 11 is preferably performed in an environment with a low water concentration and particularly preferably performed under a nitrogen atmosphere.

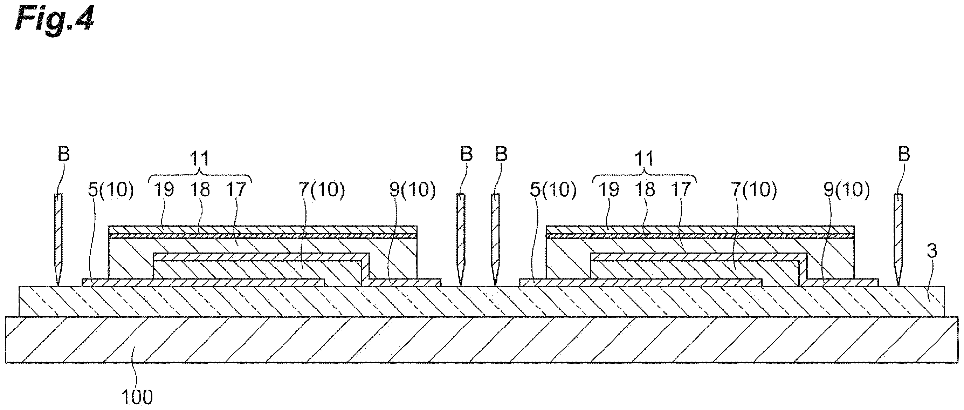

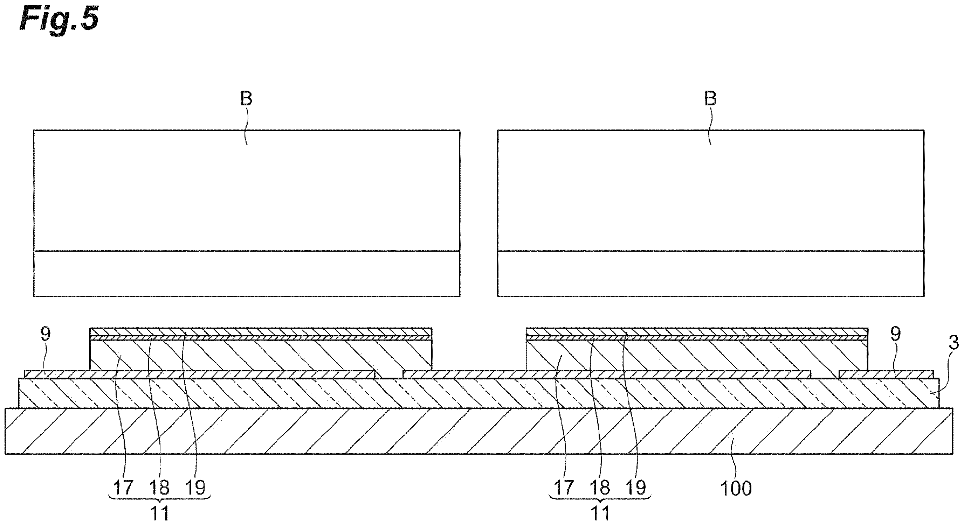

Subsequently, the plurality of organic EL parts 10 to which the sealing member 11 is bonded are separated into pieces (cutting step S06). As shown in FIG. 3, in the cutting step S06, the support substrate 3 and the sealing member 11 are cut along a cutting line L, and the plurality of organic EL parts 10 to which the sealing member 11 is bonded are separated into pieces. Specifically, as shown in FIG. 4 and FIG. 5, the support substrate 3 is supported by a support 100, and the support substrate 3 is cut by a cutting blade B. FIG. 4 is a diagram of the cross section in the X direction in FIG. 3 when viewed in the Y direction and shows a cross section at a position including the anode layer 5 and the organic functional layer 7. FIG. 5 is a diagram of the cross section in the X direction in FIG. 3 when viewed in the Y direction and shows a cross section at a position not including the anode layer 5 and the organic functional layer 7.

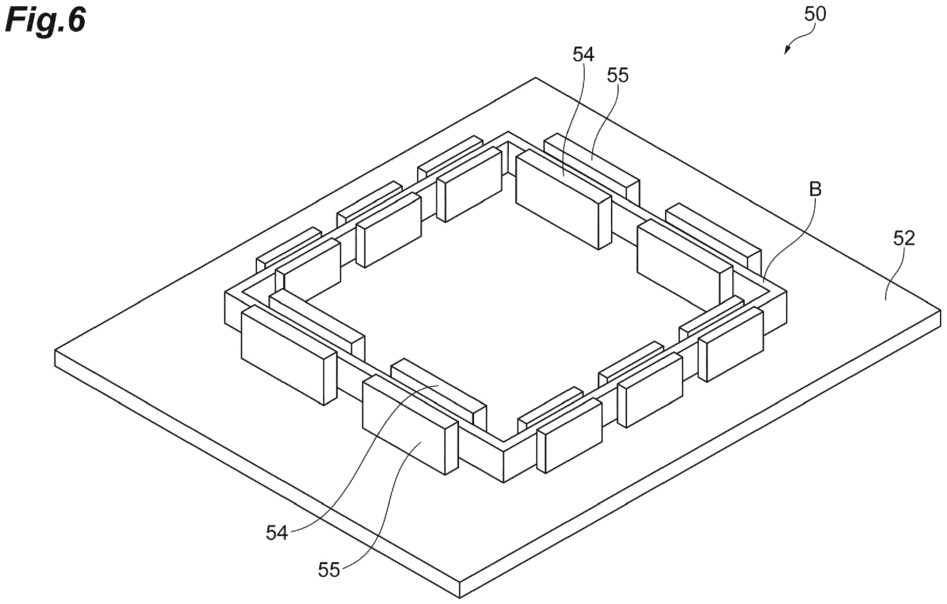

As shown in FIG. 6, the cutting blade B is provided in a cutting unit 50. The cutting unit 50 includes a cutting blade B, a holding unit (base) 52 for holding the cutting blade B, and elastic members 54 and 55. The holding unit 52 is, for example, a plate member of such as plywood. The cutting blade B has a shape conforming to the cutting line L and has a frame shape. In the present embodiment, in the cutting blade B, four blade members are provided together. For example, the cutting blade B is held by the holding unit 52 when the end on the side of the holding unit 52 of the cutting blade B is embedded in the holding unit 52. As another example, the cutting blade B may be a cut-out blade obtained by cutting a part of the holding unit 52 using a numerical control (NC) processing machine, and the cutting blade B and the holding unit 52 may be formed together. In this case, the cutting blade B and the holding unit 52 may be made of the same material.

Examples of the elastic members 54 and 55 include those of rubber and sponge. The elastic members 54 and 55 are fixed to the holding unit 52. The pair of elastic members 54 and 55 are disposed at positions on both sides of the cutting blade B. In the present embodiment, a plurality of (here, 10 sets) sets of the elastic members 54 and 55 are provided at predetermined intervals. As shown in FIG. 6, the tips (the end opposite to the end bonded to the holding unit 52) of the elastic members 54 and 55 protrude more than the tip (cutting edge) of the cutting blade B.

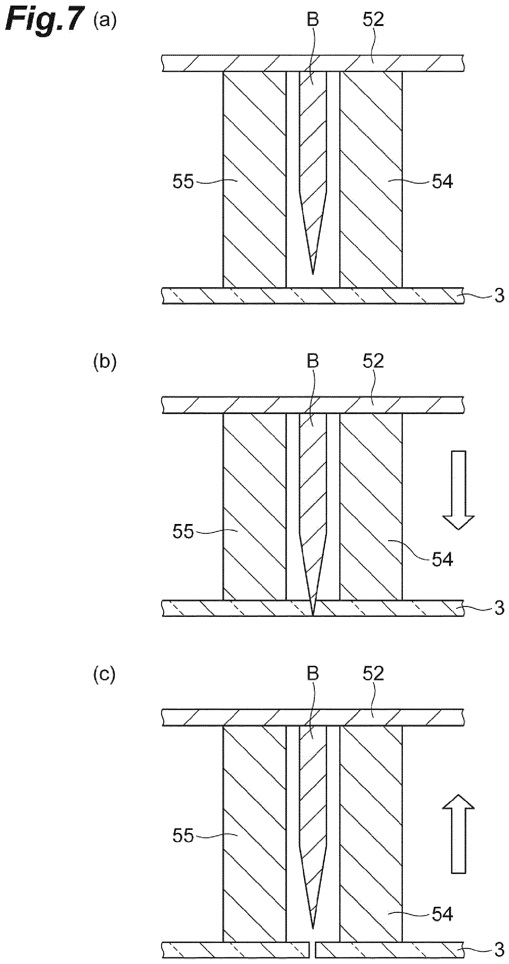

Operations (functions) of the elastic members 54 and 55 will be described with reference to FIG. 7(a) to FIG. 7(c). In FIG. 7(a) to FIG. 7(c), an exemplary form of cutting the support substrate 3 will be described. As shown in FIG. 7(a), the cutting blade B is positioned at the cutting point. In this case, the elastic members 54 and 55 of which the tips protrude from the cutting blade B press the support substrate 3. As shown in FIG. 7(b), when the cutting blade B is made to enter the support substrate 3, the elastic members 54 and 55 are interposed between the support substrate 3 and the holding unit 52, and compressed by being pressed by the holding unit 52. Then, as shown in FIG. 7(c), when the cutting blade B cuts the support substrate 3 and returns to the original position, the elastic members 54 and 55 also extend and return to the original state. When the cutting blade B is retracted from the support substrate 3, the support substrate 3 is pressed by the elastic members 54 and 55. Thereby, it is possible to prevent the support substrate 3 from being pulled by the cutting blade B and the support substrate 3 from warping when the cutting blade B is pulled up from the support substrate 3. When the cutting blade B cuts the sealing member 11, the organic EL part 10, and the support substrate 3, it is possible to prevent the sealing substrate 19 of the sealing member 11 from warping. In the cutting step S06, a plurality of cutting units 50 having the configuration described above are used. Thereby, in the cutting step S06, a plurality of organic EL elements 1 can be separated into pieces at one time.

In the cutting step S06, as shown in FIG. 4 and FIG. 5, the support substrate 3 in which the plurality of organic EL parts 10 are formed is supported by the support 100. Then, the cutting blade B of the cutting unit 50 is made to enter from the side of the one main surface 3a (the area in which the sealing member 11 is bonded is the side of the sealing member 11) of the support substrate 3. The cutting blade B is advanced to a position at which the tip thereof reaches the other main surface 3b of the support substrate 3. Thereby, the plurality of organic EL parts 10 to which the sealing member 11 is bonded are separated into pieces. Thereby, the organic EL element 1 shown in FIG. 1 is produced.

As described above, in the method for manufacturing the organic EL element 1 according to the present embodiment, the sealing member 11 including the sealing substrate 19 and the adhesive part 17 which is a pressure sensitive adhesive is bonded to the organic EL part 10. Then, the cutting blade B is made to enter from the side of the sealing member 11, and the plurality of organic EL parts 10 to which the sealing member 11 is bonded are separated into pieces. The adhesive part 17 is used for adhesion when a pressure is applied and has flexibility without being cured after adhesion. Therefore, the adhesive part 17 adheres the sealing member 11 and the organic EL part 10 due to a pressure generated when the cutting blade B enters, and also can prevent the sealing substrate 19 and the adhesive part 17 from peeling off when the cutting blade B is retracted. Therefore, in a method for manufacturing the organic EL element 1, since it is possible to prevent the occurrence of defects due to delamination, it is possible to minimize reduction in reliability.

In the method for manufacturing the organic EL element 1 according to the present embodiment, since no thermosetting adhesive is used, no heat melt cutting is required. Therefore, in the method for manufacturing the organic EL element 1, since thermal deterioration does not occur in the element and a thermosetting adhesive and the like are not attached to the cutting blade B, the maintainability is favorable, and since the heating unit is not necessary, the configuration can be simplified. Therefore, in the method for manufacturing the organic EL element 1, it is possible to efficiently separate the organic EL elements 1 into pieces while minimizing reduction in reliability of the organic EL elements 1.

In the method for manufacturing the organic EL element 1 according to the present embodiment, a plurality of organic EL parts 10 are formed at predetermined intervals in the width direction orthogonal to the longitudinal direction of the support substrate 3. In the bonding step S05, the sealing member 11 is bonded in one direction to each of rows of the organic EL parts 10 arranged parallel to each other in the width direction of the support substrate 3. Thus, it is possible to efficiently produce the organic EL element 1 by bonding the sealing member 11 in multiple rows.

In the method for manufacturing the organic EL element 1 according to the present embodiment, in the cutting step S06, the plurality of organic EL elements 1 can be separated into pieces at the same time using a plurality of cutting blades B having a frame shape. Thereby, it is possible to efficiently separate the organic EL element 1 into pieces. In a conventional heat melt cutting method, a cutting blade having a heating unit is used. In the conventional method, when a plurality of cutting blades are used, since it is necessary to provide a heating unit for each of the cutting blades, the configuration is complicated. In the method for manufacturing the organic EL element 1 according to the present embodiment, since no heating unit is required, even though a plurality of cutting blades B are used, it is possible to efficiently separate the organic EL element 1 into pieces with a simple configuration.

In the method for manufacturing the organic EL element 1 according to the present embodiment, in the cutting step S06, the cutting unit 50 including the cutting blade B provided in the holding unit 52 and a pair of elastic members 54 and 55 which are disposed at positions on both sides of the cutting blade B in the holding unit 52 and of which the tips protrude more than the tip of the cutting blade B and which have elasticity is used. In the cutting unit 50, when the cutting blade B is made to enter from the side of the sealing member 11, the elastic members 54 and 55 contract, and when the cutting blade B is retracted, the elastic members 54 and 55 extend. In this method, when the elastic members 54 and 55 of which the tips protrude more than the tip of the cutting blade B are used, the sealing member 11 is pressed by the elastic members 54 and 55 when the cutting blade B enters and is retracted. Thereby, a pressure can be applied to the adhesive part 17 when the cutting blade B is made to enter, and it is possible to prevent the sealing substrate 19 and the adhesive part 17 from peeling off by being pulled by the cutting blade B when the cutting blade B is retracted. Therefore, it is possible to prevent the occurrence of defects such as the occurrence of dark spots due to delamination. As a result, it is possible to minimize reduction in reliability of the organic EL element 1.

While embodiments of the present invention have been described above, the present invention is not necessarily limited to the above embodiments, and various modifications can be made without departing from the spirit and scope of the invention.

For example, in the above embodiment, the organic EL element 1 in which the organic functional layer 7 including a light emitting layer is disposed between the anode layer 5 and the cathode layer 9 has been exemplified. However, the configuration of the organic functional layer 7 is not limited thereto. The organic functional layer 7 may have the following configuration.
(a) (anode layer)/light emitting layer/(cathode layer)
(b) (anode layer)/hole injection layer/light emitting layer/(cathode layer)
(c) (anode layer)/hole injection layer/light emitting layer/electron injection layer/(cathode layer)
(d) (anode layer)/hole injection layer/light emitting layer/electron transport layer/electron injection layer/(cathode layer)
(e) (anode layer)/hole injection layer/hole transport layer/light emitting layer/(cathode layer)
(f) (anode layer)/hole injection layer/hole transport layer/light emitting layer/electron injection layer/(cathode layer)
(g) (anode layer)/hole injection layer/hole transport layer/light emitting layer/electron transport layer/electron injection layer/(cathode layer)
(h) (anode layer)/light emitting layer/electron injection layer/(cathode layer)
(i) (anode layer)/light emitting layer/electron transport layer/electron injection layer/(cathode layer)

Here, the symbol "/" indicates that layers between which the symbol "/" is interposed are laminated adjacent to each other. The configuration shown in the above (a) is a configuration of the organic EL element 1 in the above embodiment.

Regarding materials of a hole injection layer, a hole transport layer, an electron transport layer and an electron injection layer, known materials can be used. The hole injection layer, the hole transport layer, the electron transport layer, and the electron injection layer can be formed by, for example, a coating method as in the organic functional layer 7.

Here, the electron injection layer may contain an alkali metal or an alkaline earth metal, or an oxide or fluoride of an alkali metal or an alkaline earth metal. Examples of a film forming method for an electron injection layer include a coating method and a vacuum deposition method. In the case of the oxide and fluoride, the thickness of the electron injection layer is preferably 0.5 nm to 20 nm. Particularly, when insulation properties are strong, the electron injection layer is preferably a thin film in order to reduce increase in the drive voltage of the organic EL element 1, and the thickness thereof is preferably, for example, 0.5 nm to 10 nm, and more preferably 2 nm to 7 nm in consideration of electron injection properties.

The organic EL element 1 may include a single organic functional layer 7 or two or more organic functional layers 7. In any one of the above (a) to (i) layer configuration, when a lamination structure disposed between the anode layer 5 and the cathode layer 9 is set as a "structural unit A," as a configuration of an organic EL element including two organic functional layers 7, a layer configuration shown in the following (j) may be exemplified. Two layer configurations (structural unit A) may be the same as or different from each other.
(j) anode layer/(structural unit A)/charge generation layer/(structural unit A)/cathode layer

Here, the charge generation layer is a layer that generates a hole and an electron when an electric field is applied. Examples of the charge generation layer include a thin film made of vanadium oxide, ITO, molybdenum oxide, or the like.

When "(structural unit A)/charge generation layer" is set as a "structural unit B," as a configuration of an organic EL element including three or more organic functional layers 7, a layer configuration shown in the following (k) may be exemplified.
(k) anode layer/(structural unit B)x/(structural unit A)/cathode layer

The symbol "x" denotes an integer of 2 or more, and "(structural unit B)x" denotes a laminate in which x (structural units B) are laminated. A plurality of (structural unit B) layer configurations may be the same as or different from each other.

A plurality of organic functional layers 7 may be directly laminated without providing the charge generation layer to form an organic EL element.

In the above embodiment, a form in which the anode layer 5 is formed on the support substrate 3 has been exemplified. However, a roller in which the anode layer 5 is formed on the support substrate 3 in advance may be used.

In the above embodiment, a form in which, in the method for manufacturing the organic EL element 1, a step of heating and drying the support substrate 3 is performed has been exemplified. However, the drying step of the support substrate 3 may not necessarily be performed.

In the above embodiment, a form in which the cutting unit 50 is used in the cutting step S06 has been exemplified. However, the cutting blade used in the cutting step S06 may not include the elastic members 54 and 55. That is, the cutting blade may be used alone.

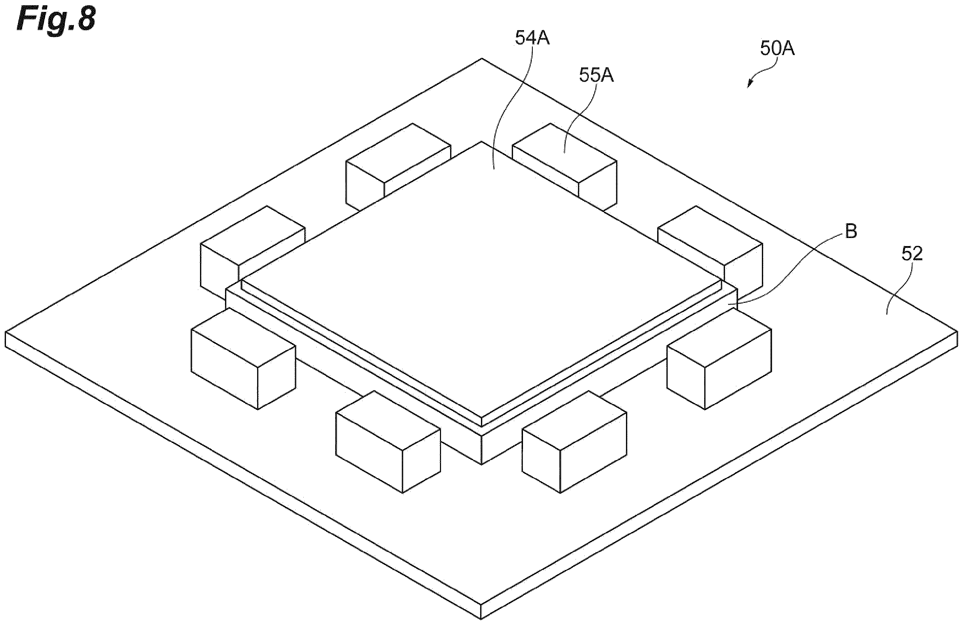

In the above embodiment, a form in which the cutting unit 50 shown in FIG. 6 has been exemplified. However, the cutting unit may be configured as shown in FIG. 8. As shown in FIG. 8, a cutting unit 50A includes the cutting blade B, the holding unit 52, and elastic members 54A and 55A. In the cutting unit 50A, the configuration of the elastic members 54A and 55A is different from that of the cutting unit 50. The elastic members 54A and 55A are disposed at positions on both sides of the cutting blade B. The elastic member 54A is positioned outside the cutting blade B and a plurality (8, here) thereof are provided at predetermined intervals. The elastic member 55A is disposed inside the cutting blade B having a frame shape and has a shape (rectangular shape) along the cutting blade B. As shown in FIG. 8, the tips (the end opposite to the end bonded to the holding unit 52) of the elastic members 54A and 55A protrude more than the tip of the cutting blade B.

In the above embodiment, a form in which the cutting blade B has a frame shape has been exemplified. However, the shape of the cutting blade is not limited thereto. The cutting blade may have any shape as long as it can cut along the cutting line.

In the above embodiment, as shown in FIG. 3, a form in which a plurality of organic EL parts 10 are formed on the support substrate 3 in the longitudinal direction (Y direction in FIG. 3) of the support substrate 3 at predetermined intervals and a plurality of organic EL parts 10 are formed in the width direction (X direction in FIG. 3) of the support substrate 3 at predetermined intervals has been exemplified. That is, a form in which two rows (a plurality of rows) of the organic EL parts 10 are formed on the support substrate 3 has been exemplified. However, at least one row of the organic EL part 10 may be formed on the support substrate 3.

In the above embodiment, the organic EL element has been exemplified as an organic device. The organic device may be an organic thin film transistor, an organic photodetector, an organic thin film solar cell or the like.

### Reference Signs List

- 1: Organic EL element (organic device)
- 3: Support substrate
- 3a: One main surface
- 5: Anode layer (first electrode layer)
- 7: Organic functional layer
- 9: Cathode layer (second electrode layer)
- 10: Organic EL part (organic device part)
- 11: Sealing member
- 17: Adhesive part (pressure sensitive adhesive)
- 19: Sealing substrate
- 50, 50A: Cutting unit
- 52: Holding unit (base)
- 54, 55, 54A, 55A: Elastic member
- B: Cutting blade

## Claims

1. A method for manufacturing an organic device, comprising:
a forming step of forming a plurality of organic device parts in which at least a first electrode layer, an organic functional layer and a second electrode layer are laminated in this order in one direction at predetermined intervals on one main surface of a support substrate which extends in the one direction;
a bonding step of bonding a sealing member which extends in the one direction in the one direction so that respective parts of the first electrode layer and the second electrode layer in the organic device parts are exposed and straddle the plurality of organic device parts; and
a cutting step of separating the plurality of organic device parts to which the sealing member is bonded into pieces,
wherein, in the bonding step, the sealing member including a sealing substrate and a pressure sensitive adhesive is bonded to the organic device part, and
wherein, in the cutting step, a cutting blade is made to enter from the side of the sealing member.

2. The method for manufacturing an organic device according to claim 1,
wherein, in the forming step, the plurality of organic device parts are formed at predetermined intervals in another direction orthogonal to the one direction, and
wherein, in the bonding step, the sealing member is bonded in the one direction to each of rows of the plurality of organic device parts arranged parallel to the other direction.

3. The method for manufacturing an organic device according to claim 1 or 2,
wherein, in the cutting step, the plurality of organic device parts are separated into pieces at the same time using a plurality of cutting blades having a frame shape.

4. The method for manufacturing an organic device according to any one of claims 1 to 3,
wherein, in the cutting step, a cutting unit including the cutting blade provided in a base and a pair of elastic members which are disposed at positions on both sides of the cutting blade in the base and of which the tips protrude more than the tip of the cutting blade and which have elasticity is used, and
wherein, when the cutting blade is made to enter from the side of the sealing member, the elastic members contract, and when the cutting blade is retracted, the elastic members extend.
